(19) Europäisches Patentamt

European Patent Office

Office européen des brevets

(11) **EP 1 271 657 A1**

(12) **DEMANDE DE BREVET EUROPEEN**

(43) Date de publication:
**02.01.2003 Bulletin 2003/01**

(51) Int Cl.⁷: **H01L 29/788**

(21) Numéro de dépôt: **02291390.9**

(22) Date de dépôt: **06.06.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **19.06.2001 FR 0108051**

(71) Demandeur: **STMicroelectronics S.A.**
**92120 Montrouge (FR)**

(72) Inventeurs:
• **Scotnicki, Thomas**
  **38920 Crolles Montfort (FR)**
• **Villaret, Alexandre**
  **38000 Grenoble (FR)**

(74) Mandataire: **Casalonga, Axel**
  **BUREAU D.A. CASALONGA - JOSSE**
  **Paul-Heyse-Strasse 33**
  **80336 München (DE)**

(54) **Dispositif semiconducteur intégréde mémoire de type DRAM et procédé de fabrication correspondant**

(57)    La structure intégrée de point mémoire comporte une couche semiconductrice enrobée d'une enveloppe isolante CH2, située entre les régions de source S et de drain D d'un transistor et intercalée entre la région de canal du transistor et sa grille de commande. Cette couche semiconductrice isolée inclut deux zones de puits de potentiel Z1,Z3 séparées par une zone de barrière de potentiel Z2 située sous la grille de commande GC du transistor.

Des moyens d'écriture Vg, Vds sont aptes à polariser la structure de point mémoire de façon à confiner des porteurs de charge sélectivement dans l'une ou l'autre des deux zones de puits de potentiel, et des moyens de lecture Vg, Vd sont aptes à polariser la structure de point mémoire de façon à mesurer le courant de drain du transistor et en déduire l'état logique mémorisé et imposé par la position des charges dans l'un des puits de potentiel Z1 ou Z3.

## FIG.1

## Description

L'invention concerne les circuits intégrés, et plus particulièrement les dispositifs semiconducteurs de mémoire.

A l'heure actuelle, on distingue trois types de dispositifs industriels à effet mémoire, intégrés sur silicium. On peut citer en premier lieu les points mémoire dynamique, de type DRAM (« Dynamic Random Access Memory » en langue anglaise) qui permettent de lire et d'écrire individuellement chaque cellule élémentaire qui les constitue. Ces cellules sont compactes, car composées généralement d'un transistor et d'un condensateur. Elles présentent un temps d'accès assez court, typiquement de l'ordre de 40 à 60 ns, mais nécessitent un rafraîchissement fréquent de l'information mémorisée.

On peut citer en deuxième lieu, les points mémoire statiques, de type SRAM (« Static Random Access Memory » en langue anglaise), dont les cellules élémentaires qui les constituent peuvent être adressées aussi bien en lecture qu'en écriture. Par ailleurs, elles présentent des temps de cycle courts avec des temps d'accès de l'ordre de 6 à 70 ns. En outre, elles retiennent l'information aussi longtemps qu'elles sont alimentées. Ces cellules restent cependant handicapées par leur faible densité, car elles sont généralement constituées de six transistors.

En troisième lieu, on peut citer les mémoires dites non volatiles, par exemple les mémoires Flash, qui peuvent retenir une information pendant plusieurs années à l'intérieur d'une zone flottante électriquement isolée par de l'oxyde par exemple, et ce sans rafraîchissement ni alimentation. Ces mémoires sont compactes, car les cellules qui les constituent sont généralement formées d'un seul transistor. Cependant, le mécanisme d'écriture par effet tunnel à travers l'oxyde d'isolement de la zone flottante est lent et nécessite de fortes polarisations se traduisant par des temps d'accès pouvant aller jusqu'à la milliseconde. Par ailleurs, ces cellules ne peuvent pas être adressées en vue d'être effacées.

L'invention a pour but de proposer un dispositif semiconducteur intégré de mémoire offrant des performances hybrides de celles des cellules Flash et DRAM classiques, tout en s'affranchissant de leurs limitations respectives.

L'invention a ainsi pour but de proposer un point mémoire qui soit adressable à l'écriture comme à l'effacement tout en disposant de la compacité d'un seul transistor.

Par ailleurs, le mode de lecture et d'écriture du point mémoire selon l'invention permet en outre un temps d'accès à l'information de quelques nanosecondes, car l'écriture de la cellule utilise des mécanismes de transport par des courants dits de « dérive » (« drift" en langue anglaise) beaucoup plus rapides que l'effet tunnel utilisé en technologie flash.

Ainsi, le principe à la base de l'invention repose sur le confinement d'une charge (négative (électrons) ou positive (trous)) dans l'un ou l'autre de deux puits de potentiel séparés par une barrière modulable par effet de champ. La structure à la base du dispositif de mémoire selon l'invention est donc en quelque sorte une « bascule isolée » possédant deux états qui dépendent de la localisation de la charge dans l'un ou l'autre des puits de potentiel.

En d'autres termes, selon une caractéristique générale de l'invention, le dispositif semiconducteur intégré de mémoire comprend une structure intégrée de point mémoire comportant une couche semiconductrice enrobée d'une enveloppe isolante (bascule isolée), située entre les régions de source et de drain d'un transistor et intercalée entre la région de canal du transistor et sa grille de commande. Cette couche semiconductrice isolée inclut deux zones de puits de potentiel séparées par une zone de barrière de potentiel située sous la grille de commande du transistor.

Le dispositif semiconducteur de mémoire selon l'invention comporte également des moyens d'écriture aptes à polariser la structure de point mémoire de façon à confiner des porteurs de charge sélectivement dans l'une ou l'autre des deux zones de puits de potentiel.

Le dispositif comporte également des moyens de lecture aptes à polariser la structure de point mémoire de façon à détecter la présence des porteurs de charge dans l'un ou l'autre des puits de potentiel et permettre ainsi de détecter l'état logique 0 ou 1 de la bascule. Cette détection peut s'effectuer de différentes façons, par exemple de façon simple en mesurant le courant de drain du transistor et par conséquent indirectement la tension de seuil du dispositif. En effet, la position des porteurs de charge dans l'un ou l'autre des puits de potentiels exerce un effet électrique suffisant sur le courant de drain du transistor pour que l'on distingue en lecture les deux états logiques 0 ou 1.

Dans une première variante de l'invention, la couche semiconductrice isolée comporte une zone centrale ayant le même type de conductivité, par exemple le type de conductivité P, que celui des régions de source et de drain du transistor (par exemple un transistor PMOS), cette zone centrale formant ladite zone de barrière de potentiel. La couche semiconductrice isolée comporte par ailleurs deux zones extrêmes respectivement situées de part et d'autre de la zone centrale, ayant un même type de conductivité mais différent de celui de la zone centrale. Ces deux zones extrêmes peuvent être par exemple dopées N, et elles forment respectivement les deux zones de puits de potentiel.

Dans une autre variante de l'invention, la couche semiconductrice isolée est non dopée, par exemple formée de silicium intrinsèque. La structure de point mémoire comporte alors deux grilles auxiliaires respectivement disposées de part et d'autre de la grille de commande du transistor. Ces deux grilles auxiliaires sont isolées de cette grille de commande et ont un même type de conductivité qui est différent de celui de la grille de commande. Ainsi, si la grille de commande est dopée P⁺, les deux grilles auxiliaires seront dopées N⁺. Les deux zones de puits de potentiel sont situées sous les deux grilles auxiliaires et sont induites électrostatiquement par celles-ci, tandis que la zone de barrière de potentiel est induite électrostatiquement par la grille de commande.

Selon un mode de réalisation de l'invention, et quelle que soit la variante utilisée, les moyens d'écriture sont aptes à polariser la grille de commande et les électrodes de source et de drain, de façon à confiner des porteurs de charge sélectivement dans l'une ou l'autre des deux zones de puits de potentiel.

Plus précisément, selon un mode de réalisation, les moyens d'écriture sont aptes à polariser l'électrode de source ou de drain auprès de laquelle on souhaite confiner les porteurs de charge, puis à polariser la grille de commande de façon à annuler la barrière de potentiel entre les deux puits de potentiel, puis à annuler la polarisation de la grille de commande et enfin à annuler la polarisation de ladite électrode.

Ainsi, les moyens d'écriture permettent aux porteurs de charge, par exemple les électrons, de passer d'une électrode à l'autre.

Selon un mode de réalisation de l'invention, les moyens de lecture sont aptes à polariser la grille de commande et le cas échéant les deux grilles auxiliaires, avec une polarisation opposée à celle utilisée par les moyens d'écriture.

L'invention a également pour objet un circuit intégré comportant au moins un dispositif intégré de mémoire tel que défini ci-avant.

L'invention propose également un procédé de fabrication d'un dispositif semiconducteur intégré de mémoire, comportant la fabrication d'un transistor MOS et la fabrication d'une couche semiconductrice enrobée d'une enveloppe isolante, située entre les régions de source et de drain du transistor et intercalée entre la région de canal du transistor et sa grille de commande, cette couche semiconductrice isolée incluant deux zones de puits de potentiel séparées par une zone de barrière de potentiel située sous la grille de commande du transistor.

Selon une première variante de l'invention, la fabrication de ladite couche semiconductrice isolée comporte

-   une épitaxie sur un substrat de silicium ayant un premier type de conductivité, d'une première couche formée d'un matériau sélectivement éliminable par rapport au silicium, par exemple un alliage de silicium-germanium,
-   une épitaxie sur ladite première couche , d'une deuxième couche semiconductrice en silicium ayant un deuxième type de conductivité,
-   la formation sur ladite deuxième couche d'une couche superficielle isolante.

Par ailleurs, la fabrication du transistor comporte une réalisation sur ladite couche superficielle isolante d'une région semiconductrice de grille de commande ayant le deuxième type de conductivité.

La fabrication de ladite couche semiconductrice isolée (bascule isolée) comporte en outre

-   une implantation de dopants dans ladite deuxième couche semiconductrice, de part et d'autre de la région de grille, de façon à former dans cette deuxième couche semiconductrice une zone centrale ayant le même type de conductivité que celui des régions de source et de drain du transistor et formant ladite zone de barrière de potentiel, et deux zones extrêmes respectivement situées de part et d'autre de la zone centrale, ayant le même type de conductivité, différent de celui de la zone centrale, et formant respectivement les deux zones de puits de potentiel,
-   une gravure de la couche isolante superficielle, de la deuxième couche semiconductrice, de la première couche d'une partie du substrat, de part et d'autre de la région de grille flanquée d'espaceurs isolants,
-   une élimination sélective de ladite première couche de façon à former un tunnel et un remplissage du tunnel par un matériau isolant, et
-   la formation d'une couche isolante latérale sur les flancs de ladite deuxième couche semiconductrice.

Le remplissage du tunnel peut s'effectuer par un dépôt conforme d'oxyde. Par ailleurs, la formation de la couche latérale isolante peut comporter une oxydation du silicium suivie d'une gravure plasma anisotrope de l'oxyde ainsi formé.

Selon un mode de mise en oeuvre de l'invention, la fabrication du transistor comporte une épitaxie des régions de source et de drain à partir du substrat, de part et d'autre de la deuxième couche semiconductrice latéralement isolée (bascule isolée).

Selon une autre variante de l'invention, compatible avec un dispositif à double grille, la fabrication de ladite couche semiconductrice isolée comporte

-   une épitaxie sur un substrat de silicium ayant un premier type de conductivité, d'une première couche formée d'un matériau sélectivement éliminable par rapport au silicium, par exemple un alliage de silicium-germanium,
-   une épitaxie sur ladite première couche, d'une deuxième couche semiconductrice en silicium non dopée,
-   la formation sur ladite deuxième couche d'une couche superficielle isolante.

Par ailleurs, la fabrication du transistor comporte une réalisation de ladite couche superficielle isolante d'une région semiconductrice de grille de commande ayant un deuxième type de conductivité.

La fabrication de ladite couche semiconductrice isolée comporte alors en outre

- la formation de deux grilles auxiliaires respectivement disposées de part et d'autre de la grille de commande du transistor, isolées de cette grille de commande, et ayant un même type de conductivité différent de celui de la grille de commande. Les deux zones de puits de potentiel sont situées sous les deux grilles auxiliaires et induites électrostatiquement par celles-ci, tandis que la zone de barrière de potentiel est induite électrostatiquement par la grille de commande,
- une gravure de la couche isolante superficielle, de la deuxième couche semiconductrice, de la première couche et d'une partie du substrat, respectivement de part et d'autre de l'ensemble formé par la grille de commande et les deux grilles auxiliaires flanquées d'espaceurs isolants,
- l'élimination sélective de la première couche de façon à former un tunnel et un remplissage du tunnel par un matériau isolant, et
- la formation d'une couche isolante latérale sur les flancs de ladite deuxième couche semiconductrice.

La formation de la grille de commande et la formation des deux grilles auxiliaires comportent par exemple

- un dépôt d'une couche d'un premier matériau semiconducteur de grille ayant un deuxième type de conductivité, par exemple le type P,
- une gravure anisotrope de la couche de matériau de grille de façon à former un bloc,
- une formation de deux évidements latéraux symétriques dans le bloc,
- la formation sur les parois des évidements d'une couche isolante,
- un remplissage des deux évidements tapissés par la couche isolante, par un deuxième matériau de grille ayant le premier type de conductivité, par exemple le type N.

Cette formation des grilles auxiliaires est par conséquent auto-aligné sur la grille de commande.
La formation des évidements latéraux comporte par exemple une oxydation thermique du bloc puis une gravure humide de l'oxyde formé.
Dans cette variante également, le remplissage du tunnel peut s'effectuer par un dépôt conforme d'oxyde, tandis que la formation de la couche latérale isolante peut s'effectuer par une oxydation du silicium suivie d'une gravure plasma anisotrope de l'oxyde.
La fabrication du transistor comporte également dans cette variante une épitaxie des régions de source et de drain à partir du substrat, de part et d'autre de la deuxième couche semiconductrice latéralement isolée.

Dans une autre variante de l'invention, également compatible avec un dispositif à double grille de commande, la couche semiconductrice isolée peut résulter d'un dépôt sur une couche isolante obtenue par exemple par une oxydation thermique du substrat.
Plus précisément, selon une telle variante, la fabrication de ladite couche semiconductrice isolée comporte

- la formation sur un substrat de silicium ayant un premier type de conductivité d'une première couche isolante,
- un dépôt sur ladite première couche isolante d'une deuxième couche semiconductrice non dopée,
- la formation sur ladite deuxième couche d'une couche superficielle isolante.

La fabrication du transistor comporte toujours une réalisation sur ladite couche superficielle isolante d'une région semiconductrice de grille de commande ayant un deuxième type de conductivité.
La fabrication de ladite couche semiconductrice isolée (bascule isolée) comporte en outre

- la formation de deux grilles auxiliaires respectivement disposées de part et d'autre de la grille de commande du transistor, isolées de cette grille de commande, et ayant un même type de conductivité différent de celui de la grille de commande, les deux zones de puits de potentiel étant situées sur les deux grilles auxiliaires et induites électrostatiquement par celles-ci, tandis que la zone de barrière de potentiel est induite électrostatiquement par la grille de commande,
- une gravure de la couche isolante superficielle, et de la deuxième couche semiconductrice, respectivement de part et d'autre de l'ensemble formé par la grille de commande et les deux grilles auxiliaires flanquées d'espaceurs isolants, et
- la formation d'une couche isolante latérale sur les flancs de ladite deuxième couche semiconductrice.

La fabrication du transistor comporte selon un mode de mise en oeuvre compatible avec cette variante, une gravure anisotrope de la première couche isolante, de part et d'autre de ladite couche semiconductrice isolée, de façon à découvrir le substrat, et une épitaxie des régions de source et de drain à partir du substrat, de part et d'autre de ladite deuxième couche semiconductrice latéralement isolée (bascule isolée).
D'autres avantages et caractéristiques de l'invention apparaîtront à l'examen de la description détaillée de modes de réalisation et de mise en oeuvre, nullement limitatifs, et des dessins annexés, sur lesquels :

- la figure 1 illustre schématiquement un premier mode de réalisation d'un dispositif de mémoire selon l'invention ;

- les figures 2a à 2d illustrent schématiquement les deux états possibles d'une bascule isolée d'un dispositif selon l'invention ;
- la figure 3 illustre schématiquement la configuration du dispositif de la figure 1 permettant de mémoriser un premier état logique, par exemple un 0 logique ;
- la figure 4 illustre une configuration du dispositif de la figure 1 permettant de stocker un deuxième état logique, par exemple un état logique 1 ;
- la figure 5 illustre une mesure de courant de drain du transistor dans l'une ou l'autre des configurations de stockage possibles de la mémoire, selon l'invention ;
- les figures 6 à 11 illustrent schématiquement les principales étapes d'un premier mode de mise en oeuvre d'un procédé de fabrication d'un dispositif de mémoire selon l'invention ;
- la figure 12 illustre un deuxième mode de réalisation d'un dispositif de mémoire selon l'invention ;
- les figures 13 et 14 illustrent les deux configurations possibles de mémorisation du dispositif de la figure 12 ;
- les figures 15 à 20 illustrent un deuxième mode de mise en oeuvre d'un procédé de fabrication d'un dispositif de mémoire selon l'invention ; et
- les figures 21 à 24 illustrent un troisième mode de mise en oeuvre d'un procédé de fabrication d'un dispositif de mémoire selon l'invention.

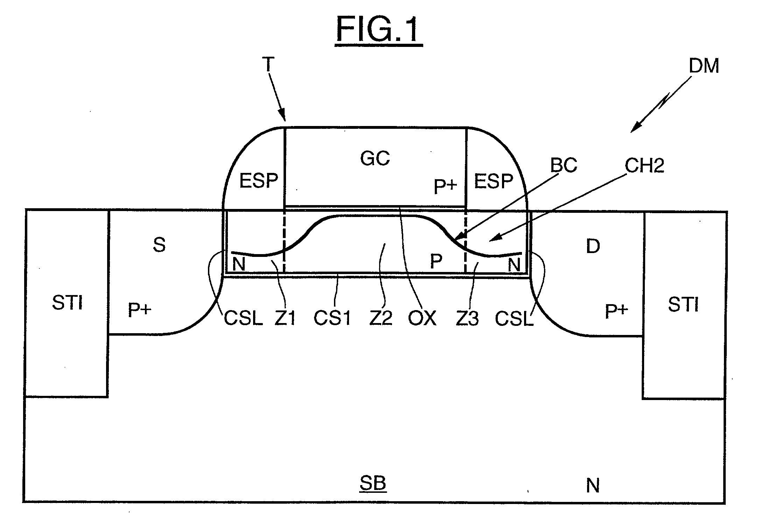

Sur la figure 1, la référence DM désigne un dispositif semiconducteur intégré de mémoire.

A titre d'exemple, dans tout ce qui suit, le transistor du dispositif de mémoire sera un transistor PMOS et la bascule isolée sera une bascule du type NPN.

La référence SB désigne un substrat semiconducteur en silicium par exemple, dopé N. Dans une zone active de substrat, délimitée par des zones d'isolement latéral STI, par exemple du type tranchées peu profondes, le dispositif DM comporte une couche semiconductrice isolée CH2, encore désignée sous le vocable de « bascule isolée ». Cette bascule isolée CH2 est intercalée entre la grille de commande GC d'un transistor PMOS référencé T, et le canal de conduction de ce transistor s'étendant entre les régions de source S et de drain D.

La bascule isolée CH2 comporte une couche semiconductrice possédant une zone centrale Z2 ayant le type de conductivité P, et deux zones extrêmes Z1 et Z3 ayant le type de conductivité N, obtenu par exemple par un dopage de type $N^+$. De ce fait, la structure de bande, ici la bande de conduction BC, présente deux zones de puits de potentiel, respectivement situées dans les zones Z1 et Z3, séparées par une zone de barrière de potentiel, située dans la zone Z2 sous la grille GC du transistor. Cette structure de bande va permettre de confiner une charge électronique au-dessus du canal de conduction à proximité de la source ou du drain, comme cela va être expliqué en détail ci-après.

Matériellement, cette couche semiconductrice de la bascule isolée est isolée du canal de conduction par une couche isolante inférieure CS1. Elle est isolée latéralement des régions de source et de drain par des couches isolantes latérales CSL. Elle est enfin isolée de la grille de commande GC par la couche d'oxyde de grille OX ainsi que par les espaceurs isolants ESP, qui sont situés de part et d'autre de la grille de commande GC. Par ailleurs, dans la direction orthogonale au plan de la figure 1, la couche semiconductrice de la bascule est isolée par la région d'isolement STI.

Avant la première utilisation de la cellule-mémoire DM, la zone flottante (bascule isolée) doit être appauvrie en trous, par exemple par une forte polarisation négative de la grille de commande GC, et chargée d'électrons par des polarisations appropriées de source et de drain.

La polarisation de la grille et des électrodes de source et de drain permet alors de transférer des électrons d'un puits de la bande de conduction à l'autre et modifier ainsi la tension de seuil du transistor. En d'autres termes, ces différentes polarisations constituent des moyens d'écriture qui permettent d'écrire (mémoriser) dans la cellule-mémoire, un état logique 0 ou un état logique 1, selon la position des électrons dans l'un ou l'autre des puits de potentiel.

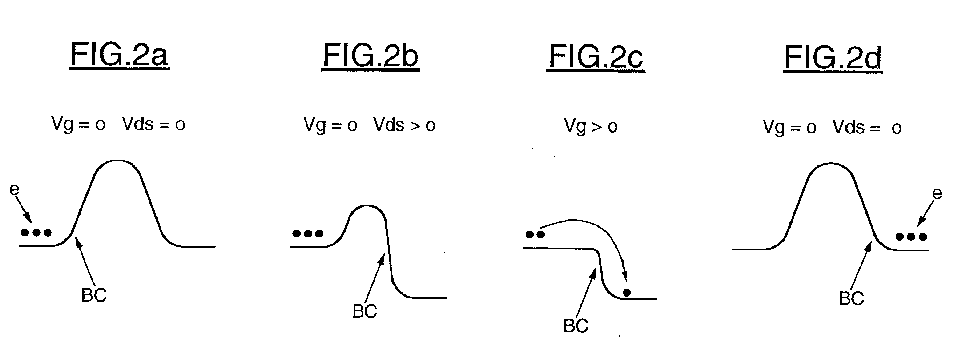

On se réfère à cet égard plus particulièrement aux figures 2a à 2d pour illustrer le transfert de charge réalisé selon la procédure d'écriture de l'invention.

On suppose, sur la figure 2a, que les porteurs de charge, ici les électrons e, sont localisés dans la zone de puits de potentiel située à gauche (sur la figure 2a) de la barrière de potentiel. La tension de polarisation de la grille Vg est nulle et la différence de tension drain-source Vds est nulle.

L'électrode source ou drain auprès de laquelle on souhaite transférer la charge est alors polarisée positivement (figure 2b). La structure de bande BC se courbe alors sous l'effet de champ.

La grille de commande est alors polarisée positivement suffisamment pour annuler la barrière de potentiel entre les deux puits (figure 2c). Les électrons affluent alors vers le minimum de la bande de conduction.

La polarisation de la grille est ensuite annulée afin de rétablir la barrière de potentiel. Lorsque la polarisation drain-source est retirée, les électrons restent alors confinés du côté où ils ont été basculés (figure 2d).

On suppose par exemple que des électrons confinés du côté du drain correspondent à un état logique mémorisé 0, tandis que des électrons confinés du côté de la source correspondent à un état logique mémorisé 1.

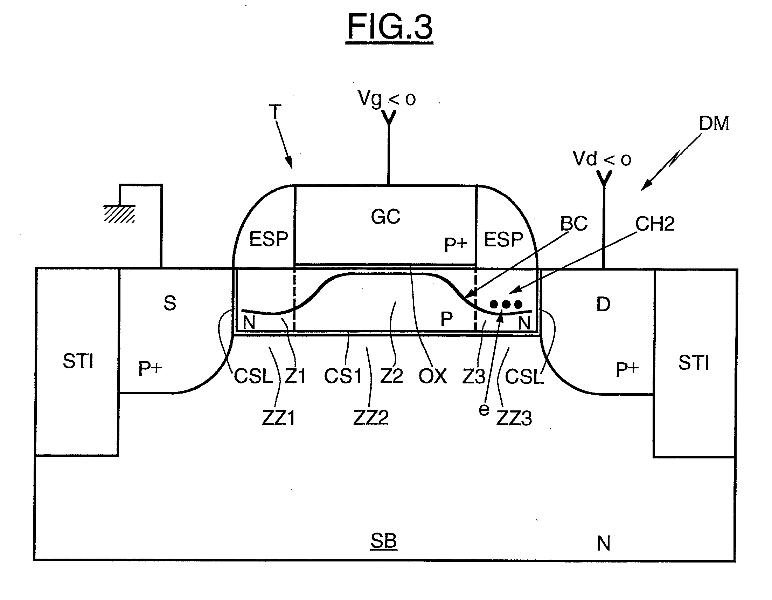

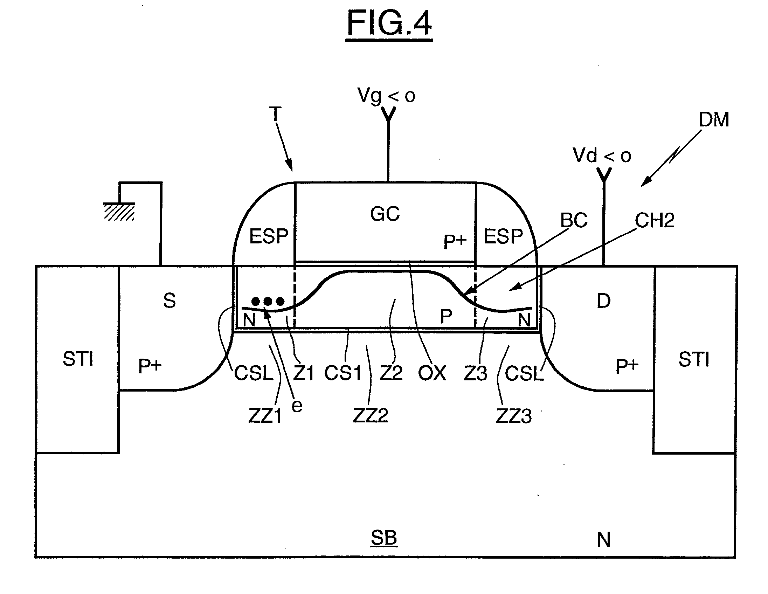

L'effet du placement des charges sur la tension de seuil est décrit en référence aux figures 3 et 4, respectivement pour la lecture de l'état 0 et de l'état 1.

Pendant la lecture de la cellule, la grille du dispositif est polarisée négativement. Cette polarisation négative permet d'attirer des électrons dans la grille près de son interface avec l'oxyde OX, et par conséquent d'inverser le canal (dopé N).

Si l'on considère tout d'abord la figure 3 qui illustre la lecture de l'état 0, les électrons libres e de la bascule sont à proximité du drain D. On distingue alors trois niveaux de peuplement sous la bascule :

- Zone centrale ZZ2 : au dessus de cette zone, la zone Z2 est appauvrie (déplétée) en permanence et contient des charges fixes négatives (accepteurs ionisés) qui attirent même sans polarisation de grille des trous dans la zone ZZ2 du canal. La tension de seuil associée à cette zone ZZ2, notée VthA, est donc inférieure à la tension de seuil qu'aurait une architecture semblable avec la bascule intrinsèque et appauvrie.

- Zone ZZ1 : au-dessus de cette zone, la bascule, dopée N$^+$ et appauvrie, contient de nombreuses charges fixes positives (donneurs ionisés) qui vont retarder le passage en inversion de la zone ZZ1. De plus, cette zone, située sous l'espaceur ESP, est décalée par rapport à la grille. De ce fait, l'effet capacitif de la grille sur le canal y est donc plus faible que dans la zone ZZ2. Il faudra par conséquent appliquer une tension de grille élevée pour que les électrons de la grille compensent d'une part l'effet des charges fixes dans la bascule, et suscitent d'autre part l'inversion du canal. La tension de seuil associée à cette zone ZZ1 sera donc supérieure à la tension de seuil qui aurait une architecture semblable avec la bascule intrinsèque et appauvrie. Cette tension de seuil est notée VthB et elle est supérieure en valeur absolue à la valeur absolue de la tension de seuil VthA.

- Zone ZZ3 : cette zone est symétrique de la zone ZZ1. Cependant, il faut tenir compte ici du confinement des électrons libres dans la partie de la bascule surplombant cette zone. Cette charge mobile négative va dans le sens d'une augmentation de l'inversion du canal. La tension de seuil associée à cette zone, notée VthC, sera donc telle que :

$$|VthA| < |VthC| < |VthB|$$

En conséquence, on peut considérer le dispositif DM comme une série de trois transistors PMOS, à tensions de seuil différentes, entre une électrode de source et un drain. La tension de seuil du dispositif de mémoire DM sera par conséquent définie par la plus forte de ces tensions. En effet, tant que la tension de grille Vg est inférieure en valeur absolue à la valeur absolue de la tension de seuil VthB, il n'y a pas injection de trous dans le canal et donc pas de courant de drain. Pour la lecture de l'état 0, la tension de seuil du dispositif est donc VthB.

Si la bascule est dans l'état logique 1, comme illustré sur la figure 4, on retrouve les trois zones d'inversion associées aux trois tensions de seuil décrites précédemment. Cependant, cette fois, la zone de plus forte tension de seuil est proche du drain, c'est la zone ZZ3. Or, pour une polarisation drain-source suffisante, les porteurs atteignent la saturation sous la grille puis sont défocalisés jusqu'au drain. Dans ces conditions, la zone du canal proche du drain, c'est-à-dire la zone ZZ3, n'a pas à être en inversion pour que le transistor conduise. La tension de seuil du dispositif de mémoire est alors la plus grande parmi la tension de seuil de la zone ZZ1 et la tension de seuil de la zone ZZ2 : c'est celle de la zone ZZ1 c'est à dire la tension VthC ( tension de seuil associée à la zone surplombée par les électrons libres).

Et, la valeur absolue de cette tension de seuil VthC est ici inférieure à la valeur absolue de la tension de seuil VthB qui était la tension de seuil de la mémoire dans l'état 0.

Par conséquent, la tension de seuil du dispositif varie avec l'état de sa bascule, on a donc bien ici une cellule à effet mémoire.

Pour lire cette cellule, on va donc mesurer le courant de drain, ce qui donne une image de la tension de seuil du dispositif et par conséquent de l'état de la mémoire.

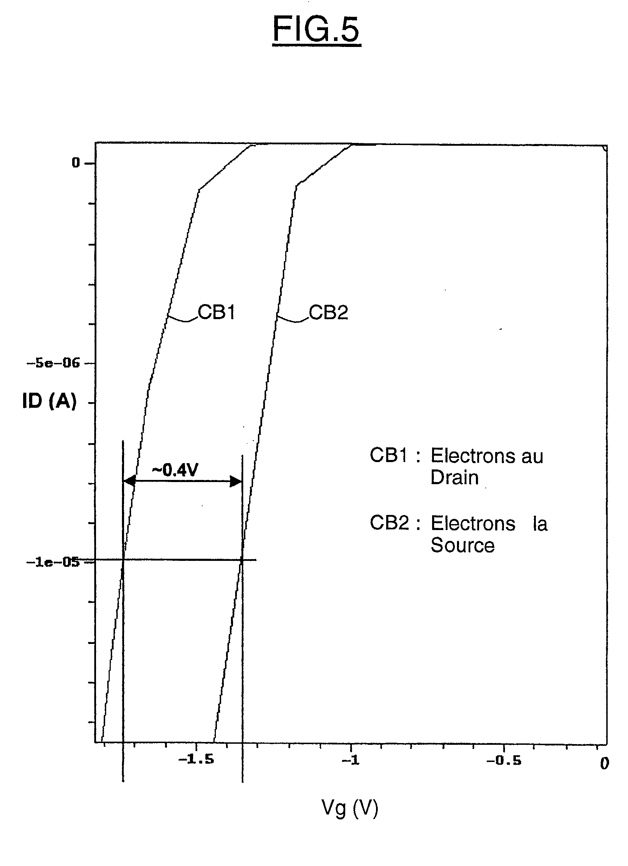

La figure 5 illustre deux courbes du courant de drain en fonction de la tension de la grille Vg. La courbe CB1 correspond à une cellule dans l'état 0 (électron au drain), tandis que la courbe CB2 correspond à une cellule dans l'état 1 avec les électrons à la source. On met donc ici en évidence cette variation de la tension de seuil du transistor en fonction de l'emplacement des charges. Des différences de tension de seuil, de l'ordre de 200 à 400 mV pour 100 mA de courant de drain ont pu être observées. Ce genre de caractéristique convient tout à fait pour des applications de type mémoire.

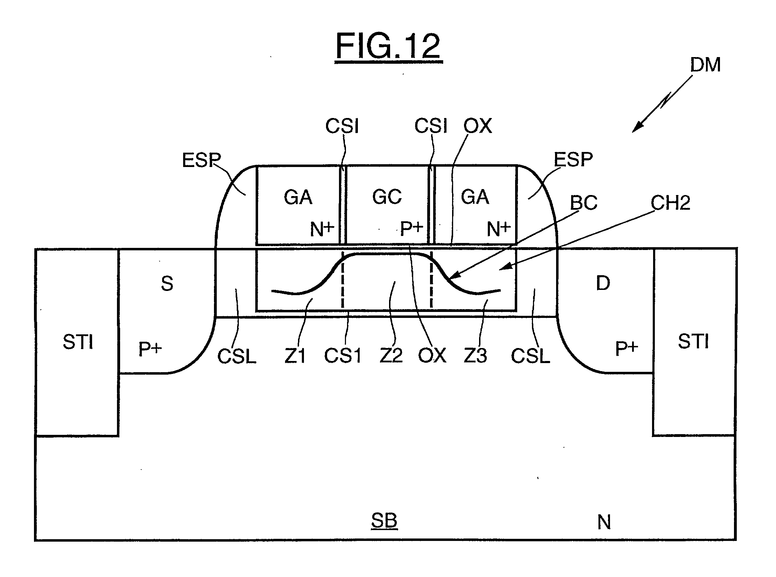

Dans le mode de réalisation illustré schématiquement sur la figure 12, la structure de bande BC à l'intérieur de la zone flottante est induite électrostatiquement par le dopage P$^+$ de la grille de commande GC du transistor PMOS et par le dopage N$^+$ de deux grilles auxiliaires GA, isolées de la grille de commande GC par une couche d'isolation CSI et respectivement situées de part et d'autre de cette grille de commande GC.

Sur la figure 12, les éléments analogues ou ayant des fonctions analogues à celles illustrées sur la figure 1, ont été représentés avec les mêmes références.

La charge électronique est introduite, lors de la première utilisation de la cellule, par effet tunnel à travers l'oxyde de grille OX sous une forte polarisation positive de la grille auxiliaire. La durée du chargement tunnel doit être suffisante pour charger une densité d'électrons d'environ 5 x 10$^{18}$ cm$^{-3}$ dans chacun des puits de potentiel Z1 et Z3.

Le transfert de charge est réalisé d'une façon analogue à celui qui a été décrit en référence aux figures 2. Pour l'abaissement de la barrière de potentiel (figure 2c), la grille de commande GC est polarisée positivement suffisamment, par exemple de l'ordre de 1 volt, tandis que la grille auxiliaire a une polarisation nulle.

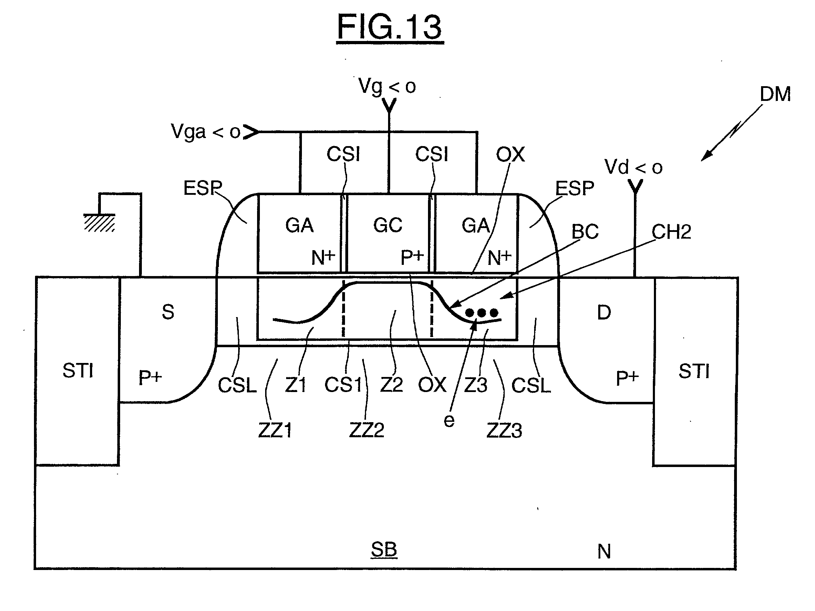

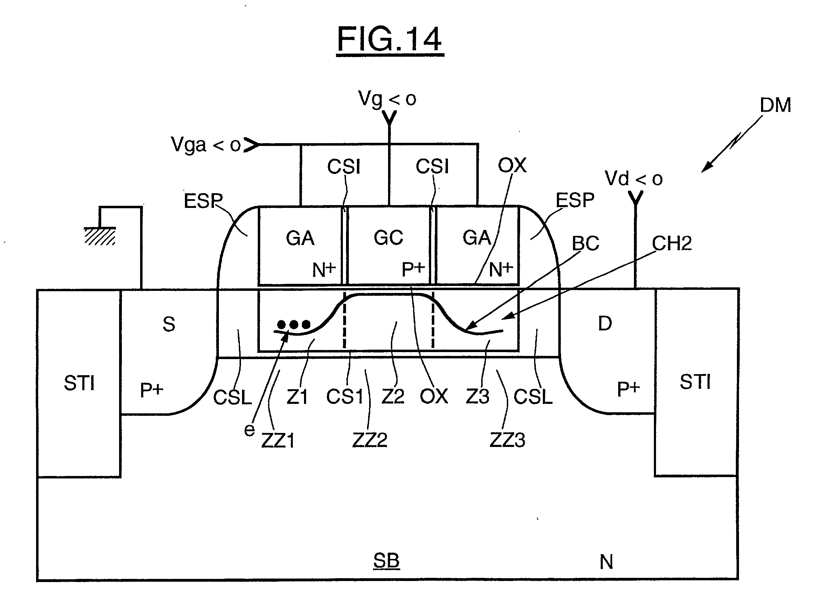

On se réfère maintenant plus particulièrement aux figures 13 et 14, pour décrire l'effet du placement des charges sur la tension de seuil lors de la lecture de l'état 0 (figure 13) ou de l'état 1 (figure 14).

Pour la lecture de la cellule, la grille de commande et les grilles auxiliaires sont polarisées négativement, par exemple avec des tensions de polarisation égales.

Lorsque l'état de la bascule est 0 (figure 13), on distingue à nouveau trois niveaux de peuplement sous la bascule :

- Zones ZZ1 et ZZ3 : la grille auxiliaire $N^+$, même polarisée, ne suscite qu'une inversion faible au niveau du canal. Cependant, la présence de la charge électronique au-dessus de la zone ZZ3 contribue aussi à l'attraction des trous dans cette zone. La tension de seuil, c'est-à-dire la tension de seuil pour laquelle le canal bascule en inversion forte, sera donc plus basse de quelques centaines de millivolts dans la zone ZZ3 que dans la zone ZZ1.

- Zone ZZ2 : cette portion du canal voit directement l'influence du potentiel de la grille dopée $P^+$. A polarisation de grille donnée (Vga=Vgc), la grille de commande GC dopée $P^+$ induit au niveau du canal un potentiel de surface inférieur d'environ 1 volt à celui imposé par la grille auxiliaire dopée $N^+$. La tension de seuil sous la grille GC est donc environ 1 volt plus basse que celle associée à la zone ZZ3.

En conséquence, on peut là encore considérer le dispositif comme une série de trois transistors PMOS, à tension de seuil différente, entre une électrode de source et un drain. La tension de seuil du dispositif sera définie par la plus forte de ces tensions. Comme pour le mode de réalisation précédemment décrit, pour la lecture de l'état 0, la tension de seuil la plus élevée est celle de la zone ZZ1.

Si la bascule est dans l'état 1 (figure 14), on retrouve trois zones d'inversion ZZ1, ZZ2 et ZZ3 associées aux trois tensions de seuil décrites précédemment. Cependant, cette fois, la zone de plus forte tension de seuil est proche du drain. Or, pour une polarisation drain-source suffisante, les porteurs atteignent la saturation sous la grille de commande, puis sont défocalisés jusqu'au drain. Dans ces conditions, la troisième zone ZZ3 n'a pas à être en inversion pour que le transistor conduise. La tension de seuil du dispositif DM est donc la plus grande parmi celle des zones ZZ1 et ZZ2. C'est la tension de seuil associée à la zone ZZ1. Et, cette tension de seuil est inférieure à la tension de seuil de la bascule dans l'état 0.

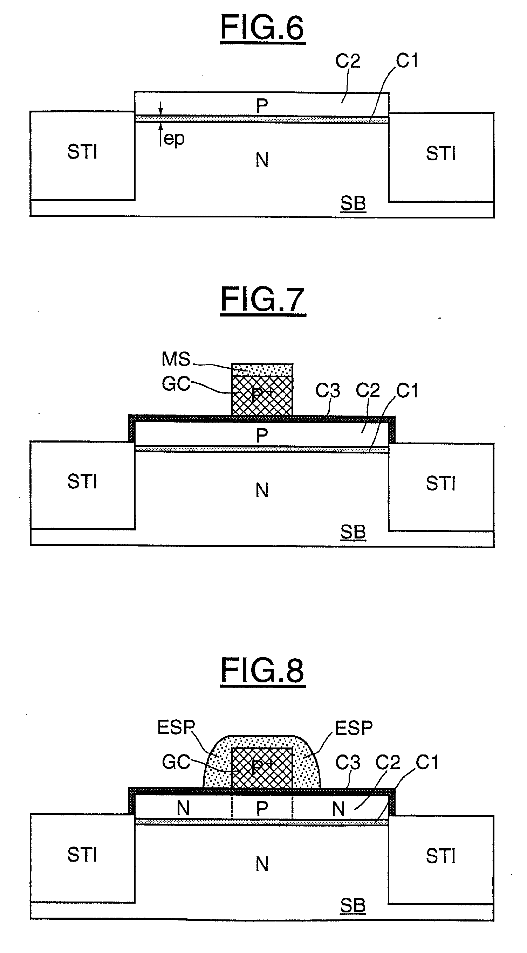

On va maintenant décrire, en se référant plus particulièrement aux figures 6 à 11, les principales étapes d'un mode de mise en oeuvre d'un procédé de fabrication selon l'invention, permettant d'obtenir un dispositif de point mémoire tel que celui illustré sur la figure 1.

Sur la figure 6, la référence SB désigne un substrat semiconducteur de type N, par exemple en silicium, comportant une zone active délimitée par des régions d'isolement latéral STI, par exemple des régions du type tranchées peu profondes (Shallow Trench Isolation, en langue anglaise).

Le procédé commence par l'épitaxie d'une première couche C1 formée d'un alliage de silicium-germanium $Si_{1-x}Ge_x$, avec par exemple x > 20%. L'épaisseur ep de cette première couche C1 définira l'épaisseur de la couche isolante inférieure de la bascule isolée.

Puis, on procède à une épitaxie sur la première couche C1, d'une deuxième couche semiconductrice C2 en silicium dopé P. C'est au sein de cette deuxième couche C2 que sera réalisée la bascule flottante. L'épaisseur de cette deuxième couche C2 est de l'ordre de la centaine d'angström.

On forme ensuite, par exemple par croissance thermique, une troisième couche C3 sur la deuxième couche C2. Cette couche C3 est par exemple du dioxyde de silicium et va constituer non seulement la couche isolante supérieure de la bascule flottante, mais également la couche d'oxyde de grille du transistor.

On dépose ensuite une couche d'un matériau semiconducteur de grille, par exemple du polysilicium dopé $P^+$ in situ. Puis, on dépose une couche de nitrure qui va servir de masque dur MS. Après gravure du masque dur et de la couche du matériau de grille, on obtient la structure de la figure 7, sur laquelle la référence GC désigne la future grille de commande du transistor.

On procède ensuite (figure 8) à une implantation $N^+$ à basse énergie, de part et d'autre de la grille GC, de façon à réaliser les zones extrêmes de la bascule isolée. Cette implantation est effectuée à basse énergie, de telle sorte que la zone implantée n'excède pas l'épaisseur du silicium de la deuxième couche C2.

Puis, des espaceurs ESP, par exemple en nitrure de silicium, sont formés de façon classique et connue en soi autour de la grille GC.

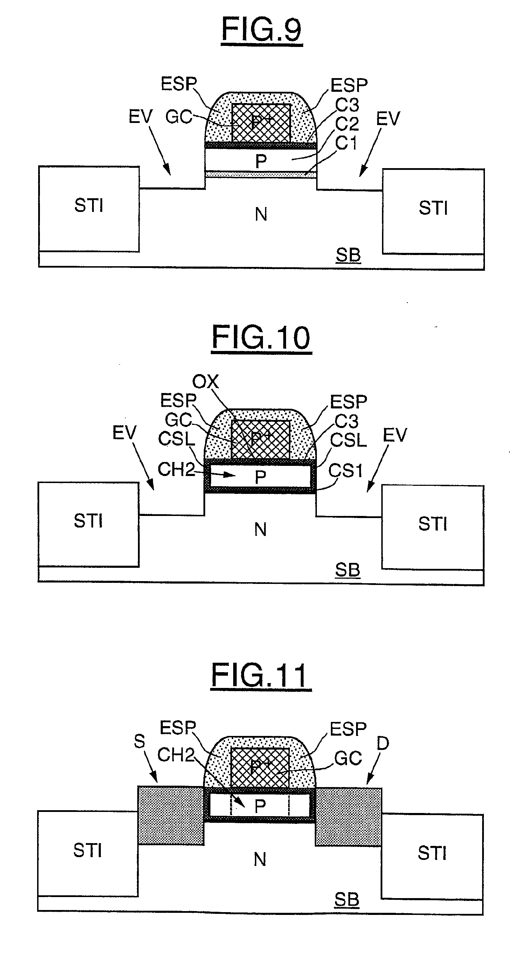

On procède ensuite (figure 9) à une gravure anisotrope de la couche isolante superficielle C3, de la deuxième couche semiconductrice C2, de la première couche C1 et d'une partie du substrat SB, de part et d'autre de la grille GC flanquée des espaceurs ESP, de façon à former des évidements EV.

Puis, on procède à une élimination sélective de la première couche C1, de façon à former un tunnel.

A cet égard, bien que l'on ait cité à titre d'exemple un alliage de silicium-germanium, le matériau sélectivement éliminable formant la couche C1 peut être tout matériau sélectivement éliminable par rapport au silicium qui, de préférence, assure une continuité de maille avec le silicium du substrat au cours de l'épitaxie. Les alliages $Si_{1-x}Ge_x$ sont recommandés car ils sont aisément éliminables sélectivement, soit au moyen d'une chimie oxydante bien connue (telle qu'une solution 40 ml HNO$_3$ 70% + 20 ml H$_2$O$_2$ + 5 ml HF 0,5%), soit au moyen d'une attaque plasma isotrope.

De préférence, on utilisera des alliages Si$_{1-x}$Ge$_x$, comportant un taux élevé de germanium car la sélectivité de gravure par rapport au silicium s'accroît avec l'accroissement du taux de germanium dans l'alliage. On peut également utiliser des alliages Si$_{1-x-y}$Ge$_x$-C$_y$ (0<x≤0,95 et 0<y<0,05) qui se comportent comme les alliages Si$_{1-x}$Ge$_x$ quant à l'élimination sélective mais qui induisent moins de contrainte avec les couches de silicium.

Le tunnel formé est alors rempli d'oxyde par dépôt conforme de façon à former la couche isolante inférieure CS1 (figure 10). Une gravure plasma anisotrope de l'oxyde permet ensuite de nettoyer d'une part les flancs de la zone flottante ainsi que les parois de fond des évidements de façon à permettre, comme on le verra plus en détail ci-après, l'épitaxie des régions de source et de drain. Cette gravure plasma anisotrope permet également de conserver l'oxyde déposé dans le tunnel.

Il convient maintenant d'isoler les flancs de la zone flottante (bascule isolée) tout en préservant la surface silicium des régions de source et de drain en vue de leur épitaxie.

On peut à cet égard utiliser la forte anisotropie de la gravure plasma d'oxyde. Plus précisément, on procède tout d'abord à une oxydation du silicium qui, au niveau des flancs de la zone flottante, s'étend sous les espaceurs ESP en nitrure. Les espaceurs vont donc protéger environ 1/3 de l'oxyde formé dans le silicium, de la gravure anisotrope qui ouvre en revanche l'accès aux régions de source et de drain. L'épaisseur de l'oxyde d'isolement latéral de la zone flottante CSL est ici déterminée par l'épaisseur de l'oxydation (figure 10).

Puis, les régions de source et de drain S et D sont épitaxiées, et dopées P$^+$ in situ. La structure finale est illustrée sur la figure 11.

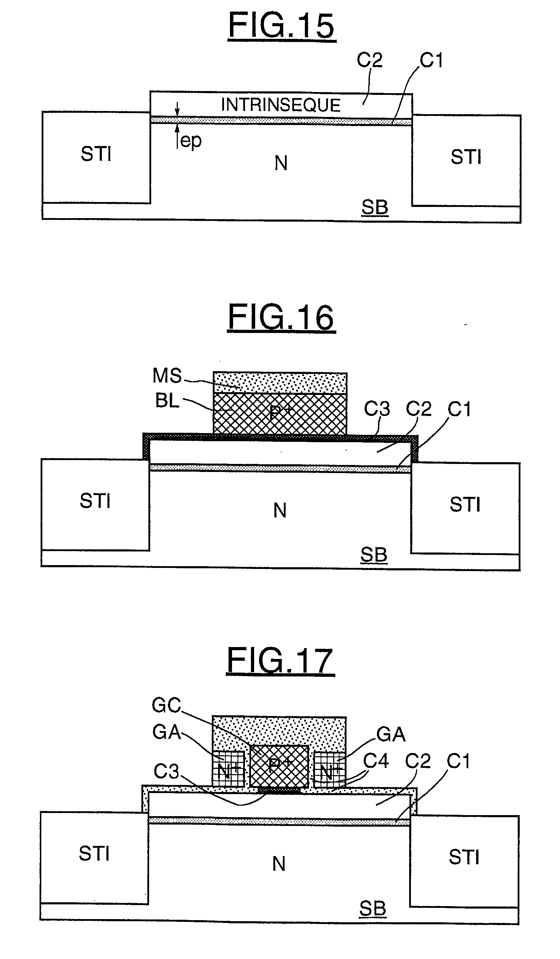

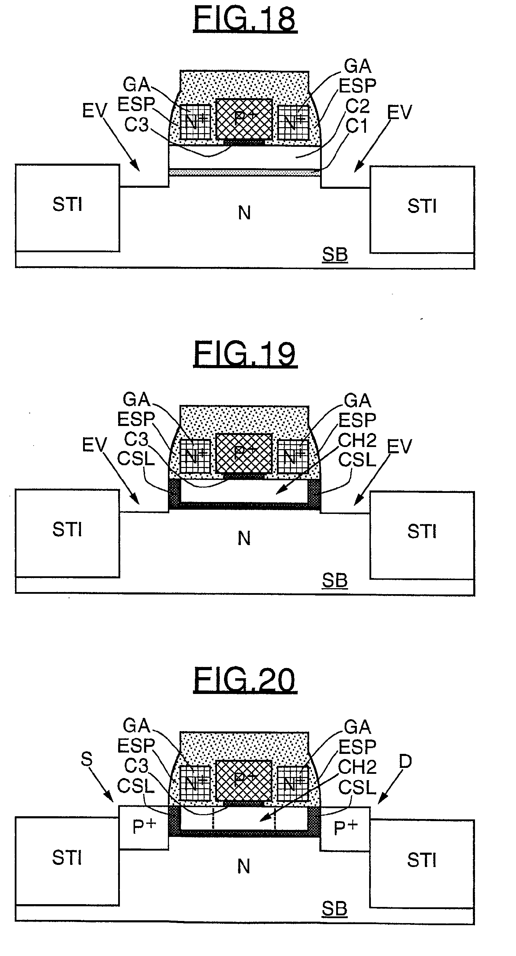

On se réfère maintenant plus particulièrement aux figures 15 à 20 pour décrire les principales étapes d'un deuxième mode de mise en oeuvre du procédé selon l'invention, permettant d'aboutir à un dispositif de mémoire tel que celui illustré sur la figure 12.

Là encore, le procédé commence par l'épitaxie d'une première couche semiconductrice C1 formée d'un matériau sélectivement éliminable par rapport au silicium. Ce matériau peut être un alliage de silicium-germanium avec un pourcentage de germanium supérieur à 20%. Là encore, l'épaisseur ep de la première couche C1 définira l'épaisseur de la couche isolante inférieure de la bascule isolée. La deuxième couche semiconductrice C2, qui est une couche de silicium intrinsèque, c'est-à-dire non dopée, est ensuite épitaxiée sur une centaine d'angström, sur la première couche C1.

Après avoir formé, par exemple par croissance thermique, une couche isolante C3 sur la surface supérieure de la couche C2 (figure 16), on dépose une couche d'un matériau semiconducteur de grille, par exemple du polysilicium, dopée P$^+$ in situ. Puis, on dépose une couche de nitrure qui servira de masque dur à la gravure grille. Après gravure du masque dur MS et du matériau de grille, on obtient un bloc BL reposant sur la couche isolante C3 (figure 16).

Le bloc BL doit ensuite être évidé latéralement et symétriquement. A cet égard, on peut procéder par une oxydation thermique, puis une gravure humide de l'oxyde formé. On obtient alors deux évidements latéraux. On tapisse alors les évidements latéraux d'une couche isolante, par exemple une fine couche de nitrure C4. Puis, on dépose une autre couche d'un matériau semiconducteur de grille, dopée N$^+$ in situ, de façon à remplir les évidements tapissés de couche isolante. Une gravure anisotrope de cette deuxième couche de matériau de grille est effectuée avec arrêt sur la couche de nitrure C4. On définit ainsi les grilles auxiliaires GA de façon auto-alignée puisque le masque dur MS de la première gravure est réutilisé.

On forme ensuite, de façon classique et connue en soi, des espaceurs isolants ESP, par exemple en nitrure de silicium, de part et d'autre des grilles auxiliaires.

Puis, on procède à une gravure de la couche C2 et de la couche C1 et d'une partie du substrat SB de façon à former deux évidements EV.

On procède ensuite (figure 19) à une gravure sélective de la couche C1, d'une façon analogue à celle qui a été décrite en référence au premier mode de mise en oeuvre du procédé de fabrication selon l'invention. Le remplissage du tunnel et la formation de la couche isolante latérale CSL sont effectués également d'une façon analogue à celle qui a été décrite en référence à la figure 10.

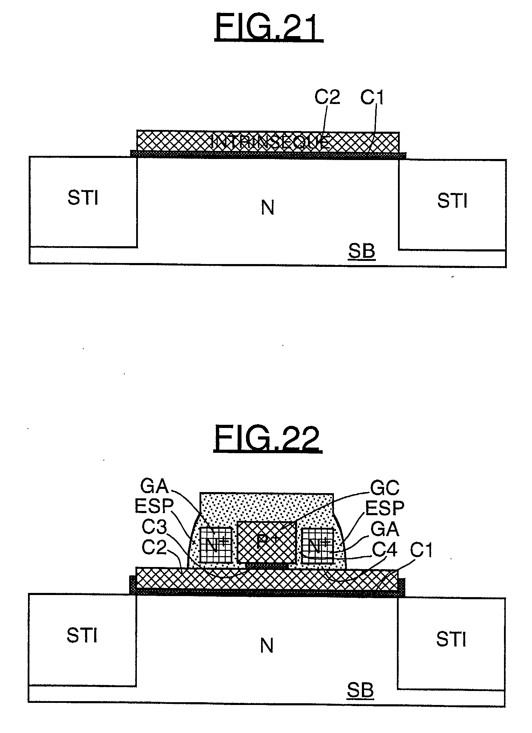

Puis, on réalise la formation des régions de source et de drain S et D (figure 20) par épitaxie de silicium dopée P$^+$ in situ.

Le mode de mise en oeuvre illustré sur les figures 21 à 24 permet également d'obtenir un dispositif de point mémoire à double grille. Cependant, le procédé débute ici par une oxydation thermique de façon à former une première couche isolante C1 qui va définir l'isolement inférieur de la bascule isolée. C'est ici l'équivalent de l'oxyde tunnel dans le mode de mise en oeuvre précédemment décrit.

Puis, on dépose la deuxième couche semiconductrice C2 en polysilicium ou en silicium amorphe non dopé. L'oxyde d'isolement supérieur est ensuite déposé suivi du polysilicium de grille P$^+$ et du masque dur de nitrure. La formation de la grille de commande GC et des grilles auxiliaires telle qu'illustrée sur la figure 22, sont identiques à celles décrites dans le mode de mise en oeuvre précédent.

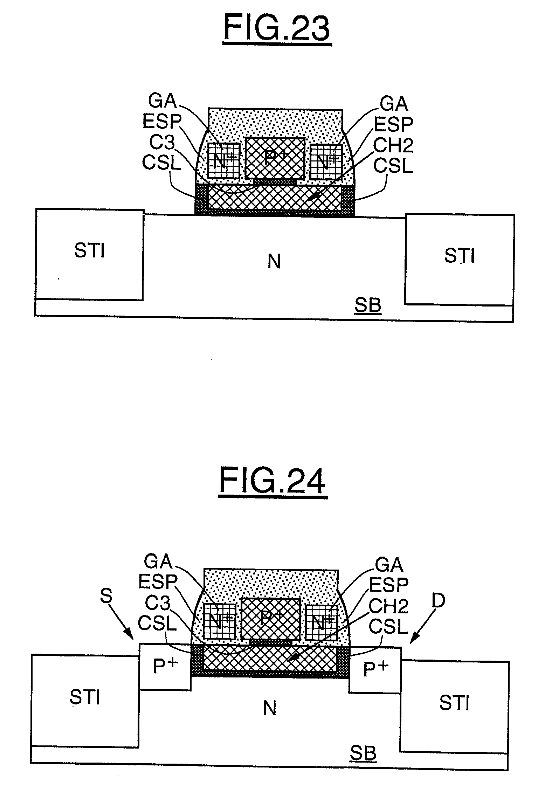

La couche C2 est ensuite gravée de façon anisotrope et de façon auto-alignée jusqu'à l'oxyde inférieur C1. Puis, les flancs sont oxydés (l'oxydation pénètre sous les espaceurs comme dans le mode de mise en oeuvre précédemment décrit). Une gravure anisotrope d'oxyde permet alors d'atteindre le silicium du substrat tout en laissant les flancs de la zone flottante CH2 oxydés (figure 23). Le procédé s'achève comme précédemment, sur l'épitaxie des régions de source et de drain dopée P$^+$ in situ. La structure finale est illustrée sur la figure 24.

Bien entendu l'invention s'applique aussi à une bascule PNP associée à un transistor NMOS moyennant des modifications dans les types de conductivité à la portée de l'homme du métier.

## Revendications

1. Dispositif semiconducteur intégré de mémoire, **caractérisé par le fait qu'**il comprend

   une structure intégrée de point mémoire comportant une couche semiconductrice enrobée d'une enveloppe isolante (CH2), située entre les régions de source (S) et de drain(D) d'un transistor et intercalée entre la région de canal du transistor et sa grille de commande, cette couche semiconductrice isolée incluant deux zones de puits de potentiel (Z1,Z3) séparées par une zone de barrière de potentiel(Z2) située sous la grille de commande (GC) du transistor,

   des moyens d'écriture (Vg, Vds) aptes à polariser la structure de point mémoire de façon à confiner des porteurs de charge sélectivement dans l'une ou l'autre des deux zones de puits de potentiel, et

   des moyens de lecture (Vg, Vd) aptes à polariser la structure de point mémoire de façon à détecter, par exemple par une mesure du courant de drain du transistor, la présence des porteurs de charge dans l'un ou l'autre des puits de potentiel.

2. Dispositif selon la revendication 1, **caractérisé par le fait que** la couche semiconductrice isolée (CH2) comporte une zone centrale (Z2) ayant le même type de conductivité que celui des régions de source et de drain du transistor (T) et formant ladite zone de barrière de potentiel, et deux zones extrêmes (Z1, Z3) respectivement situées de part et d'autre de la zone centrale (Z2), ayant un même type de conductivité différente de celui de la zone centrale, et formant respectivement les deux zones de puits de potentiel.

3. Dispositif selon la revendication 1, **caractérisé par le fait que** la couche semiconductrice isolée (CH2) est initialement non dopée, et **par le fait que** la structure de point mémoire comporte deux grilles auxiliaires (GA) respectivement disposées de part et d'autre de la grille de commande (GC) du transistor, isolées de cette grille de commande, et ayant un même type de conductivité différent de celui de la grille de commande, les deux zones de puits de potentiel étant situées sous les deux grilles auxiliaires et induites par celles-ci, tandis que la zone de barrière de potentiel est induite par la grille de commande.

4. Dispositif selon la revendication 2 ou 3, **caractérisé par le fait que** les moyens d'écriture sont aptes polariser la grille de commande (GC) et les électrodes de source et de drain de façon à confiner des porteurs de charge sélectivement dans l'une ou l'autre des deux zones de puits de potentiel.

5. Dispositif selon la revendication 4, **caractérisé par le fait que** les moyens d'écriture sont aptes à polariser l'électrode de source ou de drain auprès de laquelle on souhaite confiner les porteurs de charges, puis à polariser la grille de commande (GC) de façon à annuler la barrière de potentiel entre les deux puits de potentiel, puis à annuler la polarisation de la grille de commande et enfin à annuler la polarisation de ladite électrode.

6. Dispositif selon l'une des revendications 4 ou5, **caractérisé par le fait que** les moyens de lecture sont aptes à polariser la grille de commande (GC) et le cas échéant les deux grilles auxiliaires (GA) avec une polarisation opposée à celle utilisée par les moyens d'écriture.

7. Circuit intégré, **caractérisé par le fait qu'**il comporte au moins un dispositif selon l'une des revendications précédentes.

8. Procédé de fabrication d'un dispositif semiconducteur intégré de mémoire, **caractérisé par le fait qu'**il comporte la fabrication d'un transistor MOS et la fabrication d'une couche semiconductrice enrobée d'une enveloppe isolante (CH2), située entre les régions de source et de drain du transistor et intercalée entre la région de canal du transistor et sa grille de commande, cette couche semiconductrice isolée incluant deux zones de puits de potentiel séparées par une zone de barrière de potentiel située sous la grille de commande du transistor.

9. Procédé selon la revendication 8, **caractérisé par le fait que** la fabrication de ladite couche semiconductrice isolée (CH2) comporte

   - une épitaxie sur un substrat de silicium (SB) ayant un premier type de conductivité d'une première couche (C1) formée d'un matériau sélectivement éliminable par rapport au silicium,
   - une épitaxie sur ladite première couche (C1) d'une deuxième couche semiconductrice en silicium (C2) ayant un deuxième type de conductivité,

- la formation sur ladite deuxième couche d'une couche superficielle isolante (C3),

**par le fait que** la fabrication du transistor comporte une réalisation sur ladite couche superficielle isolante d'une région semiconductrice de grille de commande (GC) ayant un deuxième type de conductivité,
**par le fait que** la fabrication de ladite couche semiconductrice isolée comporte en outre

- une implantation de dopants dans ladite deuxième couche semiconductrice (C2) de part et d'autre de la région de grille, de façon à former dans cette deuxième couche semiconductrice une zone centrale ayant le même type de conductivité que celui des régions de source et de drain et formant ladite zone de barrière de potentiel, et deux zones extrêmes respectivement situées de part et d'autre de la zone centrale, ayant un même type de conductivité différent de celui de la zone centrale, et formant respectivement les deux zones de puits de potentiel,
- une gravure de la couche isolante superficielle (C3), de la deuxième couche semiconductrice (C2), de la première couche (C1) et d'une partie du substrat (SB), de part et d'autre de la région de grille flanquée d'espaceurs isolants (ESP),
- une élimination sélective de ladite première couche (C1) de façon à former un tunnel et un remplissage du tunnel par un matériau isolant, et
- la formation d'une couche isolante latérale (CSL) sur les flancs de ladite deuxième couche semiconductrice (C2).

**10.** Procédé selon la revendication 9, **caractérisé par le fait que** le remplissage du tunnel comporte un dépôt conforme d'oxyde, et **par le fait que** la formation de la couche latérale isolante (CSL) comporte une oxydation du silicium suivie d'une gravure plasma anisotrope de l'oxyde .

**11.** Procédé selon la revendication 9 ou 10, **caractérisé par le fait que** la fabrication du transistor comporte une épitaxie des régions de source (S) et de drain(D) à partir du substrat de part et d'autre de la deuxième couche semiconductrice latéralement isolée.

**12.** Procédé selon la revendication 8, **caractérisé par le fait que** la fabrication de ladite couche semiconductrice isolée comporte

- une épitaxie sur un substrat de silicium (SB) ayant un premier type de conductivité d'une première couche (C1) formée d'un matériau sélectivement éliminable par rapport au silicium,
- une épitaxie sur ladite première couche (C1) d'une deuxième couche semiconductrice en silicium non dopé (C2),
- la formation sur ladite deuxième couche d'une couche superficielle isolante (C3),

**par le fait que** la fabrication du transistor comporte une réalisation sur ladite couche superficielle isolante d'une région semiconductrice de grille de commande (GC) ayant un deuxième type de conductivité, **par le fait que** la fabrication de ladite couche semiconductrice isolée comporte en outre

- la formation de deux grilles auxiliaires (GA) respectivement disposées de part et d'autre de la grille de commande du transistor, isolées de cette grille de commande, et ayant un même type de conductivité différent de celui de la grille de commande, les deux zones de puits de potentiel étant situées sous les deux grilles auxiliaires et induites par celles-ci, tandis que la zone de barrière de potentiel est induite par la grille de commande,
- une gravure de la couche isolante superficielle (C3), de la deuxième couche semiconductrice (C2), de la première couche (C1) et d'une partie du substrat (SB), respectivement de part et d'autre de l'ensemble formé par la grille de commande et les deux grilles auxiliaires flanquées d'espaceurs isolants,
- une élimination sélective de ladite première couche de façon à former un tunnel et un remplissage du tunnel par un matériau isolant , et
- la formation d'une couche isolante latérale (CSL) sur les flancs de ladite deuxième couche semiconductrice.

**13.** Procédé selon la revendication 12, **caractérisé par le fait que** la formation de la grille de commande et la formation des deux grilles auxiliaires comportent

- un dépôt d'une couche d'un premier matériau semiconducteur de grille ayant un deuxième type de conductivité,
- une gravure anisotrope de la couche de matériau de grille de façon à former un bloc (BL),
- une formation de deux évidements latéraux symétriques dans le bloc,
- la formation sur les parois des évidements d'une couche isolante (CSI),
- un remplissage des deux évidements tapissés par la couche isolante , par un deuxième matériau de grille ayant le premier type de conductivité.

**14.** Procédé selon la revendication 13, **caractérisé par le fait que** la formation des évidements latéraux comporte une oxydation thermique du bloc puis une gravure humide de l'oxyde formé.

**15.** Procédé selon l'une des revendications 12 à 14, **caractérisé par le fait que** le remplissage du tunnel comporte un dépôt conforme d'oxyde, et **par le fait que** la formation de la couche latérale isolante comporte une oxydation du silicium suivie d'une gravure plasma anisotrope de l'oxyde .

**16.** Procédé selon l'une des revendications 12 à 15, **caractérisé par le fait que** la fabrication du transistor comporte une épitaxie des régions de source et de drain à partir du substrat de part et d'autre de la deuxième couche semiconductrice latéralement isolée.

**17.** Procédé selon l'une des revendications 9 à 16, **caractérisé par le fait que** le matériau sélectivement éliminable est un alliage de silicium-germanium.

**18.** Procédé selon la revendication 8, **caractérisé par le fait que** la fabrication de ladite couche semiconductrice isolée comporte

- la formation sur un substrat de silicium ayant un premier type de conductivité d'une première couche isolante (C1),
- un dépôt sur ladite première couche isolante d'une deuxième couche semiconductrice non dopée (C2),
- la formation sur ladite deuxième couche d'une couche superficielle isolante (C3),

**par le fait que** la fabrication du transistor comporte une réalisation sur ladite couche superficielle isolante d'une région semiconductrice de grille de commande ayant un deuxième type de conductivité,
**par le fait que** la fabrication de ladite couche semiconductrice isolée comporte en outre

- la formation de deux grilles auxiliaires (GA) respectivement disposées de part et d'autre de la grille de commande du transistor, isolées de cette grille de commande, et ayant un même type de conductivité différent de celui de la grille de commande, les deux zones de puits de potentiel étant situées sous les deux grilles auxiliaires et induites par celles-ci, tandis que la zone de barrière de potentiel est induite par la grille de commande,
- une gravure de la couche isolante superficielle, et de la deuxième couche semiconductrice, respectivement de part et d'autre de l'ensemble formé par la grille de commande et les deux grilles auxiliaires flanquées d'espaceurs isolants (ESP), et

- la formation d'une couche isolante latérale (CSL) sur les flancs de ladite deuxième couche semiconductrice.

**19.** Procédé selon la revendication 18, **caractérisé par le fait que** la fabrication du transistor comporte une gravure anisotrope de la première couche isolante de part et d'autre de ladite couche semiconductrice isolée de façon à découvrir le substrat, et une épitaxie des régions de source et de drain à partir du substrat de part et d'autre de ladite deuxième couche semiconductrice latéralement isolée.

## FIG.1

EP 1 271 657 A1

FIG.2a  Vg = 0  Vds = 0  BC

FIG.2b  Vg = 0  Vds > 0  BC

FIG.2c  Vg > 0  BC

FIG.2d  Vg = 0  Vds = 0  BC

# FIG.3

EP 1 271 657 A1

# FIG.4

EP 1 271 657 A1

# FIG.5

# FIG.6

STI

STI

ep

P

N

C2    C1

SB

# FIG.7

MS

GC

P+

P

N

STI

STI

C3  C2  C1

SB

# FIG.8

ESP          ESP

GC    P+

N    P    N

STI          N          STI

C3  C2  C1

SB

## FIG.9

## FIG.10

## FIG.11

FIG.12

DM

ESP

CSI OX

CSI

GA
N+

GC
P+

GA
N+

BC

CH2

ESP

S
P+

D
P+

STI

STI

CSL

Z1 CS1 Z2 OX Z3 CSL

SB

N

# FIG.13

EP 1 271 657 A1

FIG.14

## FIG.15

## FIG.16

## FIG.17

## FIG.18

## FIG.19

## FIG.20

# FIG.21

C2  C1

INTRINSEQUE

STI

N

STI

SB

# FIG.22

GA
ESP
C3
C2

GC
ESP
GA
C4  C1

N+  P  N+

STI

N

STI

SB

# FIG.23

# FIG.24

**Office européen des brevets**

## RAPPORT DE RECHERCHE EUROPEENNE

Numéro de la demande

EP 02 29 1390

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 554 552 A (CHI) 10 septembre 1996 (1996-09-10) * le document en entier * | 1,8,9 | H01L29/788 |
| A | WO 98 10925 A (FRANCE TELECOM CNET ;SCIENCE & TECHNOLOGY CORP (US); SANDIA CORP () 19 mars 1998 (1998-03-19) * le document en entier * | 1 | |
| A | US 5 753 952 A (MEHRAD) 19 mai 1998 (1998-05-19) * le document en entier * | 1 | |
| A | US 6 225 659 B1 (LIU, Y.W.) 1 mai 2001 (2001-05-01) * le document en entier * | 8 | |

DOMAINES TECHNIQUES RECHERCHES (Int.Cl.7)

H01L

Le présent rapport a été établi pour toutes les revendications

| Lieu de la recherche | Date d'achèvement de la recherche | Examinateur |
|---|---|---|
| LA HAYE | 27 septembre 2002 | Baillet, B |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**  EP 02 29 1390

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

27−09−2002

| Document brevet cité au rapport de recherche | | Date de publication | Membre(s) de la famille de brevet(s) | | Date de publication |
|---|---|---|---|---|---|
| US 5554552 | A | 10−09−1996 | US | 5717237 A | 10−02−1998 |
| WO 9810925 | A | 19−03−1998 | US | 5830575 A | 03−11−1998 |
| | | | AU | 4415297 A | 02−04−1998 |
| | | | EP | 0925178 A1 | 30−06−1999 |
| | | | JP | 2000505947 T | 16−05−2000 |
| | | | US | 6159829 A | 12−12−2000 |
| | | | WO | 9810925 A1 | 19−03−1998 |
| US 5753952 | A | 19−05−1998 | JP | 9191057 A | 22−07−1997 |
| US 6225659 | B1 | 01−05−2001 | US | 6303437 B1 | 16−10−2001 |

EPO FORM P0460

Pour tout renseignement concernant cette annexe : voir Journal Officiel de l'Office européen des brevets, No.12/82